Europäisches Patentamt

(19) European Patent Office

Office européen des brevets

(11) Publication number : **0 457 569 A2**

(12) **EUROPEAN PATENT APPLICATION**

(21) Application number : **91304359.2**

(22) Date of filing : **15.05.91**

(51) Int. Cl.⁵ : **H01M 10/48, G01R 31/36**

(30) Priority : **16.05.90 GB 9010905**

(43) Date of publication of application :
**21.11.91 Bulletin 91/47**

(84) Designated Contracting States :
**DE ES FR GB IT**

(71) Applicant : **POWER ALERT LIMITED**
**Blenheim Road, Cressex Industrial Estate**
**High Wycombe, Buckinghamshire HP12 3RS**
**(GB)**

(72) Inventor : **Butler, Edward Maurice Pierce**
**"Underwood", Witheridge Lane, Penn**
**High Wycombe, Buckinghamshire HP10 8PG**
**(GB)**

(74) Representative : **Deans, Michael John Percy et**
**al**
**Lloyd Wise, Tregear & CO. Norman House**
**105-109 Strand**
**London WC2R OAE (GB)**

(54) Indicator unit.

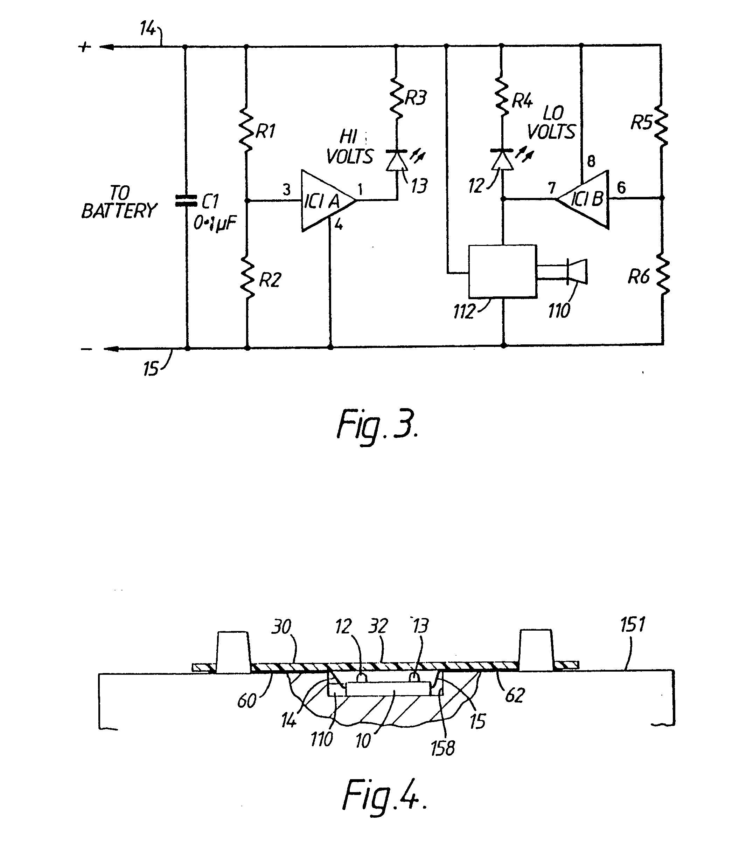

(57)   A device for indicating the charge state of a vehicle battery (50) is in the form of a flexible, multi-layer label (20) having apertures (34, 35) for securing to the battery terminal posts (52, 54). Electrical connection from the battery terminal posts (52, 54) to a voltage-sensitive indicator circuit (10) is made by a printed conductive ink (60, 62) on one layer (36) of the label structure. The indicator circuit (10) is incorporated within the label (20) and is operable to activate one or other of two light-emitting diodes (LEDs) (12, 13), one indicating a satisfactory charge state, the other a low state of charge. The label may include a translucent layer (30) having a domed portion (40) printed in two colours (38, 39) to respectively overlie the two LEDs (12, 13). The translucent portion (30) may also carry under-printed information (36). A flat piezoelectric sounder (110) is also incorporated in the multi-layer label (20) and is activated by the indicator circuit (10) to provide an audible warning of a low charge state of the battery (50). The battery may be provided with a well portion to house the indicator circuit below the label (Fig. 4).

Fig.2.

EP 0 457 569 A2

## BACKGROUND TO THE INVENTION

This invention relates to apparatus for indicating the state or condition of an electrical power source, and more particularly the voltage state of an expendable source such as a battery.

A particular, though not exclusive, application of the invention is to an indicator for use with automotive (vehicle) or similar rechargeable batteries or cells where it is often desirable to know the charge state of the battery or cell as reflected in the terminal voltage.

## PRIOR ART

U.S. Patent 4,625,174 (Eberhart) discloses an assembly having a casing designed and dimensioned to receive a specific type of domestic battery. When the battery is received within the casing, the battery terminals contact appropriately positioned casing terminals to test the battery voltage. Light-emitting diodes are provided to light according to the state of the battery.

British Patent 1,593,955 (Auergesellschaft GMBH) discloses electronic circuitry connectable to a battery to indicate the state of the battery by means of light-emitting diodes. There is no disclosure of any provision for mounting the circuit to a specific battery design.

## SUMMARY OF THE INVENTION

It will be shown how an indicator apparatus in accord with this invention can be advantageously manufactured incorporated in a label for attachment to the battery, the label carrying the manufacturer's name or trade mark, or other information.

According to the invention there is provided apparatus for indicating the voltage level of a battery comprising a circuit including an indicator that is responsive to change the state of the indicator at a predetermined voltage level, the circuit including a pair of external terminals for receiving a voltage to be monitored and a member of insulating material carrying two conductor areas and to which said external terminals are connected, said member arranged for attachment to the battery and the circuit areas having portions configured to engage respective terminals of said battery to make electrical contact therewith and apply the battery voltage to said circuit by way of said circuit terminals.

The invention and its practice will be further described with reference to the accompanying drawings.

## BRIEF DESCRIPTION OF THE DRAWINGS

Fig. 1 shows in exploded view a label form of indicator apparatus embodying the invention for use with an automotive battery;

Fig. 2 shows a cross-section of the label for mounting on a battery;

Fig. 3 shows one form of indicator circuit;

Fig. 4 shows a modification of the label indicator apparatus on a battery.

## THE PREFERRED EMBODIMENTS

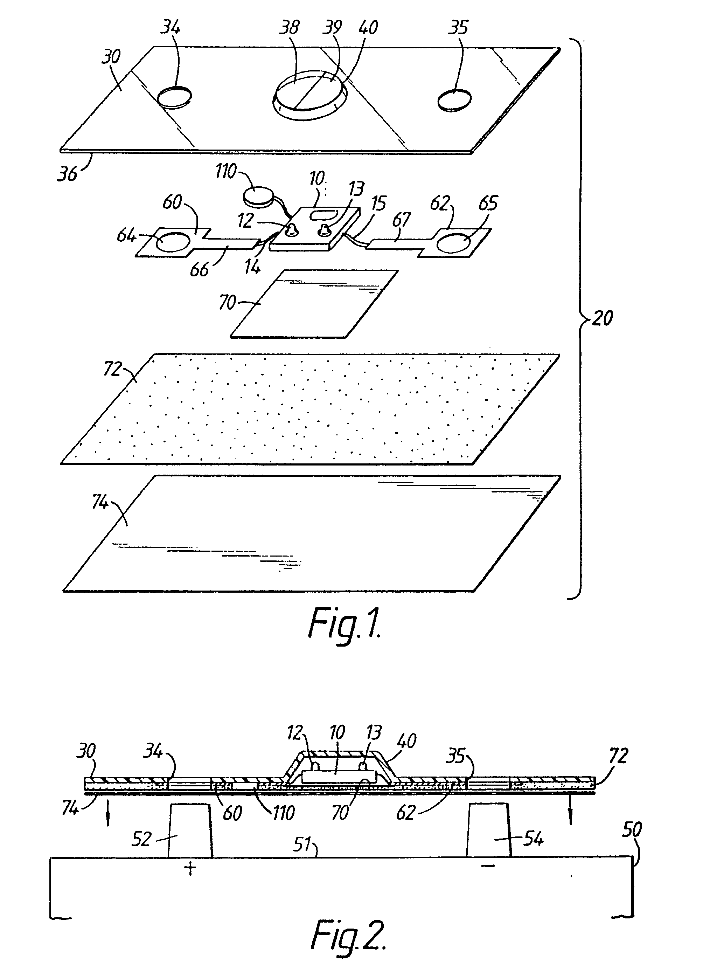

Figures 1 and 2 show a combined light emitting diode (LED) indicator unit 10 and audible warning unit 110 which is incorporated in a label assembly 20 having a top portion 30 that both provides protection as well as allowing display of information. The portion 30 of the label is specially formed at 40 to allow the LED unit to be incorporated within the label and to indicate the state of the battery 50 by monitoring its voltage.

As seen in Fig. 2 the battery has tapered terminals or poles 52, 54 of the type which can allow an appropriately apertured object to seat on the battery top. In the embodiment shown provision is made in the LED indicator unit 10 for indicating when the battery is well-charged - having a voltage of 13V or greater, assuming here that the battery is a conventional nominal 12V automotive lead-acid battery whose voltage when fully charged may rise to about 13.8V. Provision is also made in both the visual and audible indicator units 10 and 110 for indicating when the battery reaches a state of substantial discharge, indicated by the voltage falling below 11.5V.

The circuitry for monitoring the battery voltage is contained in LED unit 10 which includes a pair of LEDs 12 and 13 which are lit when the voltage exceeds 13V or falls below 11.5V respectively. The circuit components are mounted on a small piece of printed circuit board which may be coated or encapsulated for protection. Leads 14 and 15, preferably of multi-strand wire, extend from the board. The LEDs project upwardly in the installed position of the label and the base 16 of the LED unit is flat to lie against the flat upper surface 51 of the battery.

The top or outer portion 30 of the label is a rectangle of flexible, transparent, insulating plastics material, such as PVC sheet, which is formed with a bubble or domed part 40, as by heat or vacuum forming but this is not essential. The sheet may be flat. The dome 40 is sized as shown best in Fig. 2 to accommodate the LED unit within it. The sheet may be of moderate thickness, say of the order of 0.25 mm (10 thou). Also formed in the label portion 30 are two holes 34, 35 that are spaced and sized to register with the poles 52 and 54 respectively of the battery to which the label is to be attached.

The undersurface 36 of the label portion 30 is screen-printed with a conductive ink to form a pair of printed circuit conductors 60 and 62 having respective apertures 64, 65 aligned with the holes 34, 35 and respective tongues 66, 67 extending inwardly toward the dome portion which in this case is centrally positioned. For clarity of illustration the printed ink areas are shown separated from the sheet 30 in Fig. 1. The undersurface 36 may also be printed with a manufacturer's name, trade mark or whatever to be read through the transparent sheet.

The label is completed with a thin backing sheet 70 of plastic that underlies the LED unit 10 and extends beyond the dome area; a coating 72 of a conventional pressure sensitive adhesive and a protective peel-off siliconised backing 74.

The required electrical circuit from the LED unit to the printed conductors 60 and 62 is completed during assembly of the label by fixing the ends of wire conductors 14 and 15, bared if insulated wire is used, in contact with inward end portions of tongues 66, 67. This is better done by multi-strand wire whose ends can be splayed out. The ends may be fixed in position by adhesive or an adhesive tape in assembly of the label. The affixing of the label to the battery provides a pressure assisting in retaining the conductor ends in contact.

As seen in Fig. 2 upon removal of the backing paper 74 the adhesive backed label may be slipped down over the battery terminals 52, 54 which narrow upwardly, the apertures in the printed ink conductors and the label portion though being sized to engage the lower end of the terminals and provide an electrical path between the terminals through the LED unit. The label then adheres to the upper surface 51 of the battery and provides a protective enclosure for the LED unit.

The status display in the illustrated case, has the two halves of the dome differently coloured such that there is a red window half 38 above the LED 13 to indicate low charge state and a green window half 39 above LED 12 to indicate a full-charge. Red and green LEDs may be used to this end though some additional diffusion of colour may be desirable.

A suitable circuit for this is shown in Fig. 3 which uses two operational amplifiers IC1A, IC1B to whose outputs LEDs 12 and 13 are respectively connected. The connections and component values are chosen such that LEDs 12 and 13 turn-on as the applied voltage exceeds or falls below the limits above-mentioned.

It will be appreciated that there are many level sensing circuits, including comparators, Schmitt trigger devices and so on, which can be employed. Additionally different sensing information may be given. A single voltage level may be sensed with a different light on above and below that level, or a single light on either when the voltage is above or below the level. More than two lights can be employed to indicate different levels or bands. The current drawn amounts to no more than some milliamperes so that on a battery such as used in a vehicle the current drain is of negligible effect.

Figure 4 shows a modified version of the label in which the battery top 151 is formed with a shallow well or sink 158 providing a recess to accommodate the LED unit 10. In this case the top label portion does not need to be domed but can be a flat sheet with a central window portion 32 coloured and/or divided or not as required. It is possible to have a central cut-out relying on the LED light directly but that would obviously reduce the protection available.

To provide an audible warning of low battery volts, a sounder circuit 112 is connected to be activated by the output of IC1B in Fig. 3, the sounder circuit being energised from the supply rail 14. The sounder 110 may be of any of various types including piezoelectric and appropriate activating circuitry will be readily apparent to those skilled in the art.

A device such as a piezoelectric sounder can be realised in the form of a small, flat disc, like a small coin that can be readily accommodated within the label construction of Figs. 1 and 2 as shown. If necessary the label surface can be raised to accommodate the sounder and even perforated if required for better sound output. In the Fig. 4 design, a further shallow well portion or an extension of well portion 158 can be used to accommodate the sounder disc.

The circuitry 112 can be included within the LED unit 10 and connected to sounder 110 by wires 114. It could of course be made separately.

The invention has been described in the form of a combined visual/audible output. In some circumstances only one form of output may be required in which case a simplification of both the circuit and mechanical layout can be made. Although an audible output for low voltage is primarily envisaged, other voltage changes may be signalled. The provision of an audible output has particular advantage in circumstances where, as in an automobile, the battery being monitored is normally hidden from sight.

The sounder circuit 112 may be arranged to generate a buzz, warble or any other output considered appropriate to a given application.

The label construction described above may be modified so that instead of being specially made to fit over the battery terminal posts, the connections to the circuit are made by flying leads connectable to the battery terminals.

A rectangular label has been described but any other shape may be adopted as required.

## Claims

1. Apparatus for indicating the voltage level of a battery comprising a circuit including an indicator that is responsive to change the state of the indicator at a predetermined voltage level, the circuit including a pair of external terminals for receiving a voltage to be monitored and a member of insulating material carrying two conductor areas and to which said external terminals are connected, said member arranged for attachment to the battery and the circuit areas having portions configured to engage respective terminals of said battery to make electrical contact therewith and apply the battery voltage to said circuit by way of said circuit terminals.

2. Apparatus as claimed in Claim 1 in which said conductive areas are formed of a conductive ink deposited on said insulating member.

3. Apparatus as claimed in Claim 1 or 2 in which said indicator comprises a device for emission of sound.

4. Apparatus as claimed in Claim 1, 2 or 3 in which said indicator comprises means providing a visual output.

5. Apparatus as claimed in any preceding claim in which said circuit is enclosed within an assembly of which said insulating member provides one outer side.

6. Apparatus as claimed in Claim 5 in which said conductor areas are at an inner surface of said insulating member.

7. Apparatus as claimed in Claim 6 in which said insulating member is at least partially transparent and carries other printing at said inner surface to be visible when looking at said outer surface.

8. Apparatus as claimed in Claim 7 in which said insulating member comprises sheet material.

9. Apparatus as claimed in Claim 7 or 8 in which said sheet material is formed to provide a domed or concave portion extending out from the sheet and in which portion said indicator is received.

10. Apparatus as claimed in Claim 7 or 8 in which said sheet material comprises one side of a self-adhesive label assembly.

11. Apparatus as claimed in Claim 9 in which a layer of adhesive is applied to the inner side of said sheet material and is covered by a removable backing sheet.

12. Apparatus as claimed in any preceding claim in which said insulating member and said conductor areas are apertured to enable them to be passed over the terminals of a battery thereby locating the member on the battery with the conductor areas in contact with respective terminals.

13. Apparatus for indicating the voltage level of a battery comprising means for engaging the terminals of the battery to make electrical contact therewith and a circuit connected to said means to receive the battery voltage and including an indicator, the circuit being responsive to change the state of the indicator from a first static state to a second static state on the voltage passing through a predetermined voltage level, and said indicator including at least a sound emitting device as an audible indicator.

14. Apparatus as claimed in Claim 13 in which said circuit is protected by a member having an area through which sound from said indicator passes and in which said member has conductive areas on an internal surface thereof by way of which said circuit is connected to said means for receiving the battery voltage.

15. Apparatus as claimed in Claim 14 in which said conductive areas are formed from a conductive ink applied to said internal surface.

Fig.1.

Fig.2.

Fig.3.

Fig.4.